# DEMANDE DE BREVET EUROPEEN

(11) **EP 2 182 631 A2**
(43) Date de publication de la demande: **05.05.2010**
(21) Numéro de dépôt: 09166903.6
(22) Date de dépôt: 30.07.2009
(51) Int. Cl.: H03F 1/22, H03F 3/60

(54) **Cellule amplificatrice hyperfréquences large bande à gain variable et amplificateur comportant une telle cellule**

(30) Priorité: 28.10.2008 FR 0805979
(71) Demandeur: Thales, 92200 Neuilly Sur Seine (FR)
(72) Inventeur: Dueme, Philippe, 91400 Orsay (FR); Plaze, Jean-Philippe, 78390 Bois d'Arcy (FR); Auric, Claude, 78117 Chateaufort (FR)
(74) Mandataire: Lucas, Laurent Jacques

(57) **Abrégé**

L'invention concerne une cellule Amplificatrice hyperfréquences large bande à gain variable et un amplificateur distribué comportant une telle cellule.

La cellule amplificatrice comporte, deux transistors à effet de champ en montage cascode, un premier transistor à effet de champ T1 monté en source commune, sa source S étant connectée à un potentiel de référence (M), en série avec un deuxième transistor à effet de champ T2 monté en grille commune, sa source S étant connectée au drain D du transistor T1, sa grille G étant connectée au potentiel de référence à travers une capacité de découplage de grille (Cd), une entrée (E) hyperfréquences par la grille du TEC T1 et une sortie (S) hyperfréquences par le drain du deuxième transistor à effet de champ T2,

La cellule amplificatrice comporte, entre le point commun de connexion entre le drain D du premier transistor à effet de champ T1 et la source S du deuxième transistor à effet de champ T2 et le potentiel de référence (M), une capacité de découplage de circuit de réglage (Cr) en série avec un élément résistif (T3) de valeur réglable pour faire varier le gain (G) de la cellule amplificatrice.

Applications : circuits intégrés hyperfréquences (MMIC), chaînes d'émission et/ou réception RF.

## Description

L'invention concerne les chaînes hyperfréquences des systèmes électroniques, et en particulier, les systèmes devant travailler dans une large bande de fréquence.
Les chaînes hyperfréquences assurent notamment des fonctions d'émission et/ou de réception de signaux hyperfréquences et sont réalisées par exemple en technologie MMIC (Monolithic Microwave Integrated Circuits, en langue anglaise).
Une fonction de base assurée par les chaînes hyperfréquences est l'amplification mise en oeuvre par des circuits amplificateurs dont il est souvent nécessaire de contrôler le gain. Le contrôle de gain permet d'augmenter la dynamique effective, en particulier d'une chaîne de réception, et d'adapter les caractéristiques de la chaîne au niveau du signal à traiter, en temps réel. Ce contrôle peut prendre deux formes qui sont en général réalisées de façon différente :
- Un ensemble amplificateur dont le gain peut varier de façon continue,
- Un ensemble amplificateur dont le gain peut prendre deux (ou plus) valeurs discrètes, aussi connu sous le nom de « plot de gain »

Les systèmes d'émission ou de réception travaillant dans une large bande de fréquence imposent aux circuits d'amplification de posséder les caractéristiques suivantes :
- fonctionner sur une large bande de fréquence
- être capable de commuter d'une valeur de gain à une autre en un temps limité, qui peut être très court (10 à 30 ns)
- un facteur de bruit qui ne doit pas augmenter plus rapidement que le gain diminue,
- une puissance de sortie (ou des caractéristiques de linéarité) peu affectée par la capacité à accepter des variations de gain.

Dans le cas d'une chaîne d'amplification dont le gain doit varier de façon continue (ou une variation à commande numérique par paliers), il existe deux méthodes principales connues de réalisation:
Une première méthode de réalisation d'une chaîne d'amplification consiste dans la combinaison d'un amplificateur et d'un atténuateur variable.
   Dans cette première méthode on utilise un atténuateur variable pour sa relative facilité de mise en oeuvre et la bonne connaissance de ce type de fonction. Que l'atténuateur variable soit composé d'éléments de commutation à base de diodes (généralement du type « PIN ») ou de transistors à effet de champ non polarisés (ou « transistors froids »), un atténuateur variable est simple à concevoir et à utiliser.
   Un atténuateur variable est caractérisé principalement par son minimum d'atténuation désigné aussi par atténuation résiduelle, c'est-à-dire ses pertes lorsque l'atténuation est réglée à son minimum, et sa dynamique d'atténuation, c'est à dire l'atténuation maximale diminuée de l'atténuation résiduelle. Le critère principal pour définir la dynamique d'atténuation est que le gain de la fonction d'atténuation (exprimé en dB) doit varier d'une quantité fixe entre deux états d'atténuation, dans toute la bande de fréquence utile. En pratique, plus cette bande est large et plus l'atténuation minimum est importante ce qui représente des pertes supplémentaires à compenser.
Il existe deux manières d'envisager la combinaison d'un amplificateur et d'un atténuateur variable pour former la chaîne d'amplification :
   1. L'atténuateur variable est placé avant l'amplificateur. Cette configuration comporte l'inconvénient d'augmenter le facteur de bruit de la chaîne d'amplification. Pour des signaux faibles (en général en réception), l'atténuateur est réglé à l'atténuation minimum et la valeur en dB de l'atténuation résiduelle vient directement s'ajouter au facteur de bruit de l'amplificateur qui suit.
   2. L'atténuateur variable est placé après l'amplificateur. Dans cette autre configuration, la puissance maximum de sortie de la chaîne d'amplification est diminuée de la valeur de l'atténuation utilisée, c'est-à-dire l'atténuation résiduelle pour des signaux faibles ou une plus forte atténuation pour des signaux forts. En outre, l'amplificateur reste exposé directement aux signaux les plus forts (pour lesquels l'atténuateur sera réglé à l'atténuation maximum), ce qui peut avoir des conséquences dommageables en termes de linéarité se traduisant par la génération de signaux harmoniques ou de produits d'intermodulation.
Dans les deux configurations, le gain maximum de la chaîne d'amplification est égal (en petit signal) au gain de l'amplificateur diminué de l'atténuation résiduelle de l'atténuateur variable. Plus cette atténuation résiduelle est forte, plus il faudra augmenter le gain ce qui a pour conséquence une augmentation de la consommation de l'amplificateur.
Une autre méthode de réglage de gain d'une chaîne d'amplification consiste à contrôler le point de polarisation des composants actifs d'un amplificateur. Cette autre méthode est encore plus difficile à mettre en oeuvre que la précédente consistant dans la combinaison d'un amplificateur et d'un atténuateur variable, par le fait qu'elle a tendance à cumuler les inconvénients suivants :
   - le facteur de bruit et la puissance (ou la linéarité) de sortie de la chaîne sont très dépendants des points de polarisation des composants actifs,
   - l'utilisation d'une variation de ces points de polarisation pour faire varier le gain vient en général à l'encontre des objectifs recherchés.
Pour corriger les défauts des amplificateurs hyperfréquences à gain réglable, l'invention propose une cellule amplificatrice hyperfréquences large bande à gain variable comportant, deux transistors à effet de champ en montage cascode, un premier transistor à effet de champ (T1) monté en source commune, sa source S étant connectée à un potentiel de référence (M), en série avec un deuxième transistor à effet de champ (T2) monté en grille commune, sa source S étant connectée au drain D du premier transistor à effet de champ (T1), sa grille G étant connectée au potentiel de référence (M) à travers une capacité de découplage de grille (Cd), une entrée E hyperfréquences par la grille du premier transistor à effet de champ (T1) et une sortie S hyperfréquences par le drain du deuxième transistor à effet de champ (T2),
   entre le point commun de connexion du drain D du premier transistor à effet de champ (T1) avec la source S du deuxième transistor à effet de champ (T2) et le potentiel de référence (M), une capacité de découplage de circuit de réglage (Cr) en série avec un élément résistif (Rr) de valeur réglable pour faire varier le gain (G) de la cellule amplificatrice.
   l'élément résistif étant un troisième transistor à effet de champ (T3) connecté entre sa source S et son drain D, sa grille G étant connectée à une source (Sr) de tension continue, de potentiel Vgcom variable, pour faire varier la résistance entre la source S et le drain D dudit troisième transistor à effet de champ (T3),
**caractérisée en ce qu**'elle comporte une résistance de grille (Rg) en série avec la capacité de découplage de grille (Cd) du deuxième transistor à effet de champ (T2) monté en grille commune pour améliorer stabilité du montage cascode à gain réglable.

Dans une réalisation, la cellule amplificatrice comporte une entrée de commande pour régler la valeur de l'élément résistif.

L'invention concerne aussi un amplificateur hyperfréquences large bande à gain variable comportant une entrée (Eamp) et une sortie (Samp) de signal hyperfréquences, un amplificateur distribué à n cellules amplificatrices (Cl1, Cl2,...Cli,...Cln), selon l'invention, chacune des cellules ayant une entrée de commande pour régler la valeur de l'élément résistif, l'amplificateur distribué comportant une ligne de transmission d'entrée (Lg) d'un signal d'entrée Ue appliqué à l'entrée (Eamp) de signal hyperfréquences, et une ligne de transmission de sortie (Ld) du signal d'entrée amplifié, les lignes étant activement couplées entre elles par les cellules amplificatrices Cl1, Cl2,...Cli,...Cln, n étant un entier supérieur à 1,
la ligne de transmission d'entrée (Lg) ayant une de ses deux extrémités reliée à l'entrée (Eamp) de signal hyperfréquences, la ligne de transmission de sortie (Ld) dudit signal d'entrée Ue amplifié ayant une extrémité de sortie de l'amplificateur distribué connectée à la sortie (Samp) de signal hyperfréquences, le gain (G) de l'amplificateur distribué étant fonction de la valeur identique, pour chacune des cellules amplificatrices, de l'élément résistif.

Avantageusement, les extrémités libres des deux lignes de transmission sont chargées par des respectives impédances de valeurs égales à l'impédance caractéristique de la respective ligne de transmission à laquelle chacune est connectée.

Dans une réalisation de l'amplificateur, l'élément résistif de valeur réglable des n cellules amplificatrices étant le troisième transistor à effet de champ connecté entre sa source S et son drain D, sa grille G étant connectée à une source (Sr) de tension continue, de potentiel Vgcom variable, pour faire varier la résistance entre la source S et le drain D dudit troisième transistor à effet de champ, il comporte une ligne de distribution commune dudit potentiel Vgcom variable aux n cellules.

La solution proposée consiste à ajouter au moins un élément à résistance variable dans un montage actif complexe de type montage dit « cascode ». Le montage cascode, lorsqu'il est réalisé à partir de transistors à effet de champ (ou TEC), est constitué d'un TEC en configuration dite « source commune » en série avec un TEC en configuration dite « grille commune »

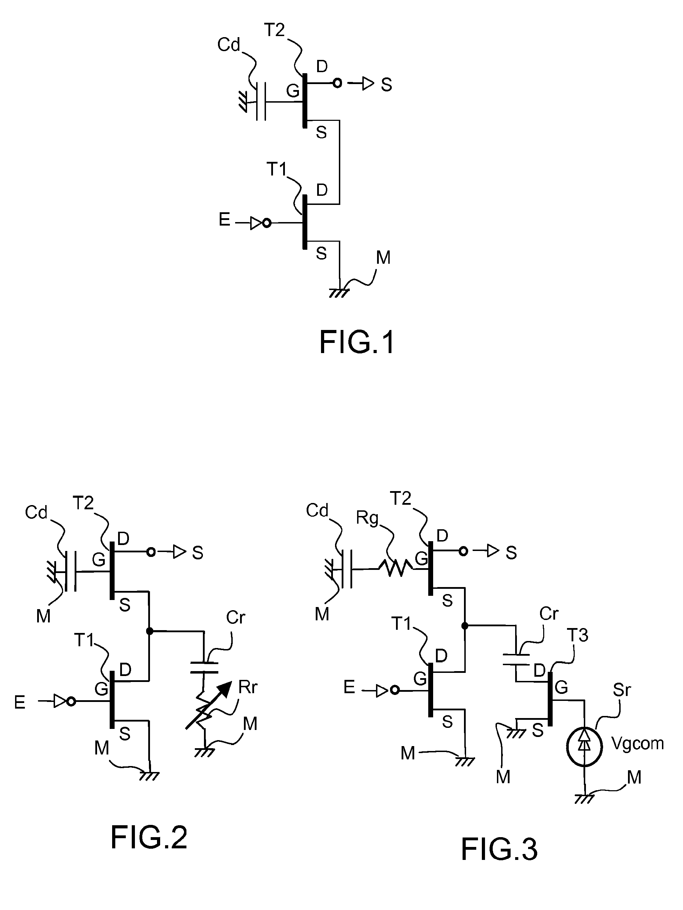

La figure 1 montre un montage cascode de l'état de l'art comportant deux transistors à effet de champ, un premier transistor à effet de champ T1 et un deuxième transistor à effet de champ T2 en série. L'entrée E hyperfréquences est effectué par la grille du premier transistor à effet de champ T1 et la sortie S par le drain du deuxième transistor à effet de champ T2

Ce type de montage est très utilisé en hyperfréquences du fait de la minimisation de sa capacité d'entrée due à l'effet Miller.

L'invention sera mieux comprise à l'aide d'exemples de réalisation d'une cellule amplificatrice et un amplificateur comportant une telle cellule en référence aux dessins indexés dans lesquels :
- la figure 1, déjà décrite, montre un montage cascode de l'état de l'art comportant deux transistors à effet de champ en série ;
- la figure 2 montre le principe d'une cellule hyperfréquences à gain variable de type cascode, selon l'invention ;
- la figure 3 montre un exemple de réalisation d'une cellule hyperfréquences, selon l'invention, comportant les deux transistors à effet de champ de la figure 2 ;
- la figure 4 montre les variations du paramètre S2,1 représentant le gain G (dB) de la cellule hyperfréquences selon l'invention, en fonction de la fréquence F ;
- les figures 5a et 5b représentent respectivement, sur un abaque de Smith, la variation du paramètre S1,1 et du paramètre S2,2 de la cellule de la figure 3 ;
- la figure 6 montre un schéma synoptique de principe d'un amplificateur distribué de l'état de l'art ;
- la figure 7 montre un exemple de réalisation d'un amplificateur distribué selon l'invention à trois cellules hyperfréquences Cl1, Cl2, Cl3 ;
- les figures 8a, 8b et 8c montrent respectivement les paramètres S2,1, S1,1 et S2,2 d'un amplificateur distribué à contrôle de gain, selon l'invention, à quatre cellules amplificatrices en fonction de la fréquence F;
- les figures 9a et 9b représentent respectivement la puissance de sortie Pout et la variation du gain G de l'amplificateur distribué à quatre cellules amplificatrices en fonction de la puissance d'entrée Pin pour un réglage de gain faible, des cellules ;
- les figures 10a et 10b représentent respectivement la puissance de sortie Pout et la variation du gain G de l'amplificateur distribué à quatre cellules amplificatrices en fonction de la puissance d'entrée Pin pour un réglage de gain fort, des cellules et ;
- les figures 11 et 12 montrent respectivement les variations de gain en fonction de la fréquence F et les variations relatives du facteur de bruit correspondant aux variations de gain G de l'amplificateur distribué à quatre cellules amplificatrices, lorsque la tension de commande Vgcom varie de -1 V (gain maximum) à +0,4V (gain minimum).
   La figure 2 montre le principe d'une cellule hyperfréquences à gain variable de type cascode, selon l'invention, comportant deux transistors à effet de champ (ou TECs).

La cellule de la figure 2 comporte les deux transistors à effet de champ T1 et T2 de la figure 1 en série. Le drain du premier transistor à effet de champ T1 est connecté à la source du deuxième transistor à effet de champ T2.
Le premier transistor à effet de champ T1 fonctionne en configuration dite « source commune » la source du premier transistor à effet de champ T1 étant connectée à un potentiel de référence, dans cette réalisation une masse M.
Le deuxième transistor à effet de champ T2 fonctionne en configuration dite « grille commune » sa grille étant connectée au potentiel de référence M par l'intermédiaire d'une capacité de découplage de grille Cd. Cette capacité de découplage de grille Cd représente un court circuit pour les signaux hyperfréquences. La grille du deuxième transistor à effet de champ T2 est donc pour les signaux hyperfréquences à la masse M.
L'entrée E hyperfréquences de la cellule se fait par la grille du premier transistor à effet de champ T1 et la sortie S hyperfréquences par le drain D du deuxième transistor à effet de champ T2.
Selon une principale caractéristique de l'invention, la cellule hyperfréquences comporte un circuit de réglage de gain connecté entre le point de connexion entre le drain D du premier transistor à effet de champ T1 et la source S du deuxième transistor à effet de champ T2 et le potentiel de référence M, comportant une capacité de découplage de circuit de réglage Cr en série avec un élément résistif Rr de valeur variable.
Les capacités de découplage Cd et Cr ont pour rôle de bloquer les tensions continues de polarisation des transistors à effet de champ vis-à-vis du potentiel de référence M mais présentent une impédance quasi nulle pour les signaux hyperfréquences.
L'élément résistif variable Rr peut être une résistance ajustable, un transistor tel qu'un TEC, ou tout autre élément dont la valeur résistive peut être changée.
La figure 3 montre un exemple de réalisation d'une cellule hyperfréquences, selon l'invention, comportant les deux transistors à effet de champ T1 et T2 de la figure 2 en montage cascode et un circuit de réglage de gain comportant un TEC froid.

Un TEC froid ne comporte pas de polarisation continue entre son drain D et sa source S. Le TEC froid se comporte comme une résistance variable entre le drain D et la source S en fonction d'une tension continue appliquée entre sa grille G et le drain D ou la source S.
Le circuit de réglage de gain de la figure 3 comporte un troisième transistor à effet de champ T3 connecté par sa source S à la masse M et par son drain D à une des électrodes de la capacité de découplage Cr du circuit de réglage, l'autre électrode étant connectée au point de connexion entre le drain D du premier transistors à effet de champ T1 et la source S du deuxième transistors à effet de champ T2. Une source Sr de tension continue, de potentiel Vgcom réglable par rapport à la masse M, est appliquée à la grille du troisième transistor à effet de champ T3 pour régler le gain du montage cascode.
Dans certaines conditions le montage cascode peut devenir instable. La stabilité du montage cascode à gain réglable selon l'invention peut être améliorée en ajoutant une résistance de grille Rg en série avec la capacité de découplage de grille Cd du deuxième transistor à effet de champ T2 monté en grille commune.
La figure 3 montre la résistance de grille Rg du deuxième transistor à effet de champ T2 en série avec la capacité de découplage de grille Cd.

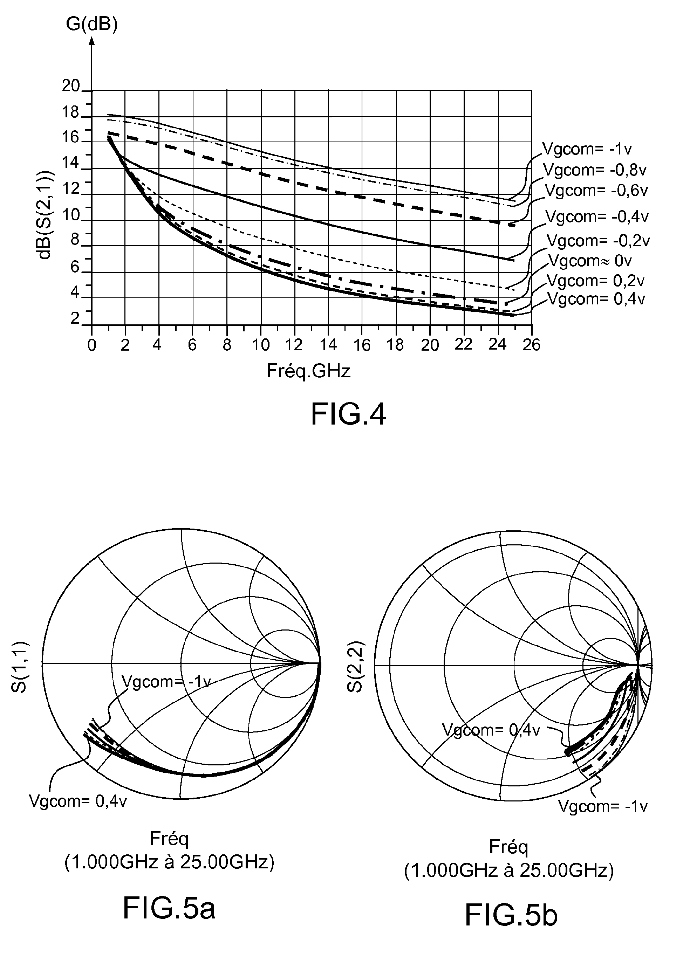

La figure 4 montre les variations du paramètre S2,1 représentant le gain G (dB) de la cellule hyperfréquences selon l'invention, en fonction de la fréquence F et pour différentes tensions continues de grille Vgcom à savoir, -1, -0,8, -0,6, -0,4 -0,2, 0, +0,2, +0,4 Volt appliquées à la grille du troisième transistor à effet de champ T3. Les paramètres S soient, S1,1 S1,2 S2,1 S2,2 définissent de façon connue les caractéristiques électriques en petit signal d'un quadripôle.
Les figures 5a et 5b représentent respectivement, sur un abaque de Smith, la variation du paramètre S1,1 et du paramètre S2,2 de la cellule de la figure 3 pour les mêmes tensions continues de grille Vgcom désignées ci-dessus (voir figure 4).
La sortie S de la cellule hyperfréquences est chargée par une impédance caractéristique de 50 Ω. Dans cette réalisation et pour les résultats montrés par la suite, la résistance de grille Rg du deuxième transistor à effet de champ T2 a une valeur de 20 Ω.
Lorsque la tension continue de grille Vgcom appliquée à la grille du troisième transistor à effet de champ T3 est à -1 V, le troisième transistor à effet de champ T3 est alors pincé, la résistance entre drain et source est élevée, le gain G(dB) (paramètre S2,1) de la cellule hyperfréquences est maximum.
Lorsque la tension de grille Vgcom est à +0,4V le troisième transistor à effet de champ T3 est alors passant, la résistance entre le drain et la source est faible, le gain G(dB) est minimum.
Les figures 4, 5a et 5b montrent que, pour la cellule hyperfréquences de la figure 3 commandée par la tension continue de grille Vgcom du troisième transistor à effet de champ T3, le paramètre de transmission S2,1 varie d'environ 10 dB sur une large bande de fréquences. Le paramètre S1,1 représentant le coefficient de réflexion d'entrée E de la cellule, varie peu (variations limitées aux fréquences hautes). Le paramètre S22 représentant le coefficient de réflexion de sortie S de la cellule, varie plus mais dans des proportions limitées. En particulier, sa phase reste très constante. On peut remarquer que la diminution du gain G s'accompagne d'une certaine stabilisation du dispositif (le module de S2,2 cesse de dépasser la valeur critique de 1).

L'invention concerne aussi un amplificateur à structure distribuée comportant de telles cellules hyperfréquences.

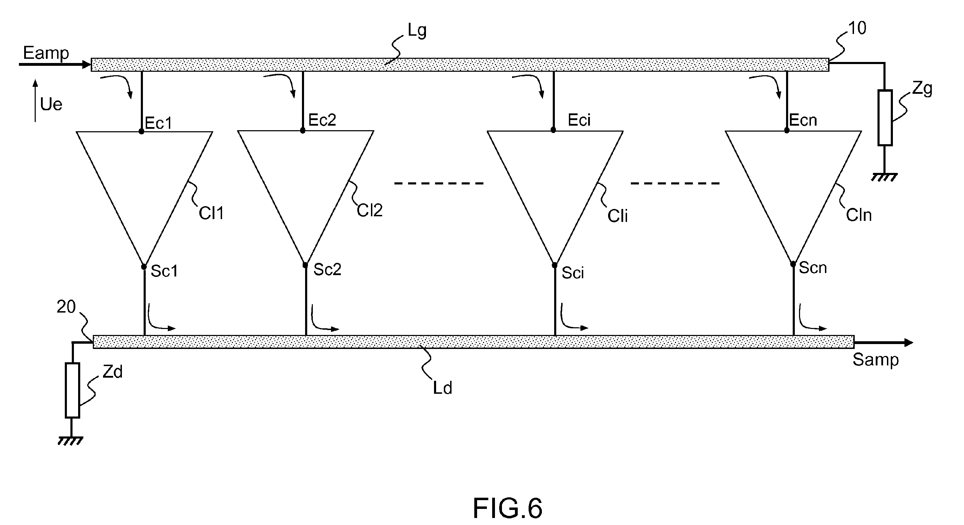

La figure 6 montre un schéma synoptique de principe d'un amplificateur distribué de l'état de l'art.
L'amplificateur distribué de la figure 6 est un dispositif bien connu comportant essentiellement deux lignes de transmission, une ligne de transmission d'entrée Lg et une ligne de transmission de sortie Ld. Ces lignes sont parcourues par le signal utile et activement couplées entre elles par des éléments actifs Cl1, Cl2,...Cli,...Cln, n étant le nombre d'éléments actifs de l'amplificateur distribué représentés par des triangles sur la figure 6.
Le nombre n d'éléments actifs n'est pas déterminant et peut être, très généralement, n'importe quel entier à partir de 2. Dans la pratique, ce nombre n est souvent compris entre 3 et 6.

Les éléments actifs symbolisés par des triangles peuvent être des simples transistors à effet de champ, auquel cas la ligne d'entrée Lg est appelée « ligne de grille » et la ligne de sortie Ld « ligne de drain ».
Ces lignes de grille et de drain sont des lignes artificielles constituées des capacités internes aux transistors auxquels sont connectées des inductances (éventuellement liées entre elles par des mutuelles inductances). Les lignes ont un comportement très constant depuis les fréquences basses (le continu en théorie, les limitations pratiques venant des circuits de polarisation des transistors) jusqu'à des fréquences de coupures liées à la tailles des transistors, donc aux caractéristiques fondamentales du circuit (gain, puissance de sortie, ...), ce qui confère à ce type de circuit un comportement dit « large bande ».
L'amplificateur distribué de la figure 6 comporte une entrée hyperfréquences Eamp d'un côté de la ligne d'entrée Lg recevant une tension d'entrée Ue et une sortie Samp du côté de la ligne de sortie Ld fournissant un signal Ue amplifié. Les extrémités libres 10, 20 des deux lignes Lg, Ld sont en principe chargées par des respectives impédances Zg, Zd appelées impédances terminales ou charges annexes de valeurs égales en principe à l'impédance caractéristique de la ligne à laquelle chacune d'elles est connectée.
Dans le cas d'une réalisation en technologie MMIC, les connexions des charges annexes Zg, Zd sur les extrémités libres des lignes se font généralement sur la puce et par conséquent ne sont pas disponibles.

Les éléments actifs Cl1, Cl2,...Cli,...Cln, symbolisés par des triangles peuvent aussi être constitués de n'importe quelle autre structure active.
L'amplificateur distribué utilisant des cellules cascode de l'état de l'art telles que représentées à la figure 1, étant bien connu, la présente invention consiste à utiliser, pour chaque élément actif, une cellule hyperfréquences à gain variable selon l'invention telle que représentée aux figures 2 et 3.
En effet, il est particulièrement intéressant d'inclure la cellule cascode commandable en gain dans une structure dite « distribuée » qui est par nature « large bande ».

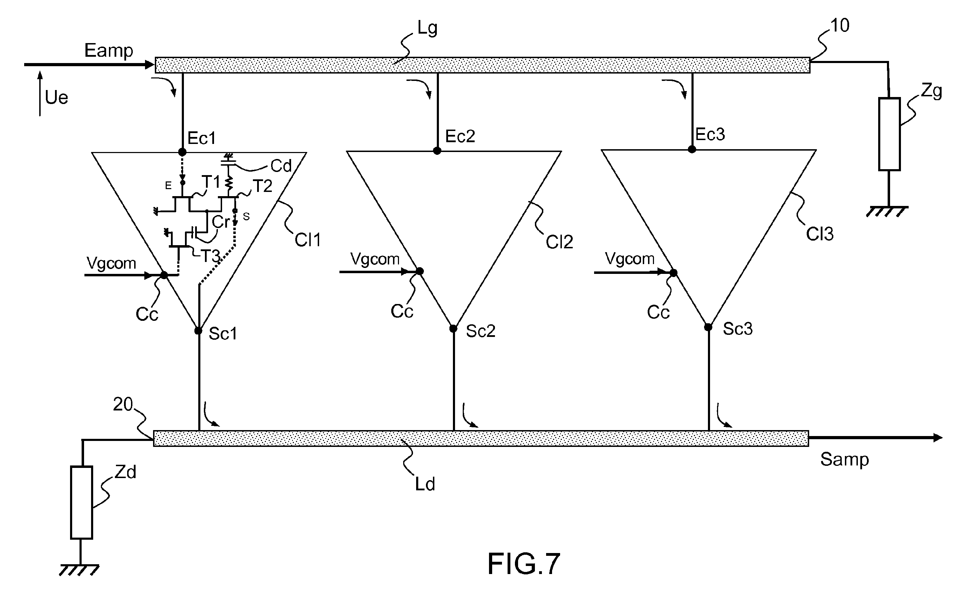

La figure 7 montre un exemple de réalisation d'un amplificateur distribué selon l'invention à trois cellules hyperfréquences Cl1, Cl2, Cl3 selon la configuration comportant les trois transistors à effet de champ T1, T2, T3 telle que représentée à la figure 3.
La première cellule Cl1, montrée plus en détail sur la figure 7, comporte les trois transistors à effet de champ. Les premier et deuxième transistors à effet de champ T1, T2 en montage cascode et le troisième transistor à effet de champ T3 pour la commande de gain de la cellule hyperfréquences.
Chacune des cellules Cl1, Cl2, Cl3 comporte une entrée de contrôle Cc recevant la tension de grille Vgcom pour commander le gain des cellules.

Dans une réalisation de l'amplificateur distribué de la figure 7, le gain des trois cellules hyperfréquences Cl1, Cl2, Cl3 est commandé pour être identique. A cet effet l'amplificateur distribué comporte une ligne de distribution commune dudit potentiel Vgcom variable aux n cellules.

Le mode de réalisation de ce nouveau type d'amplificateur distribué selon l'invention est parfaitement compatible d'une technologie de type « MMIC ».

Les figures suivantes donnent les résultats d'un exemple de simulation préliminaire d'un tel circuit décrit en utilisant les modèles de la filière PH25 de la société UMS.

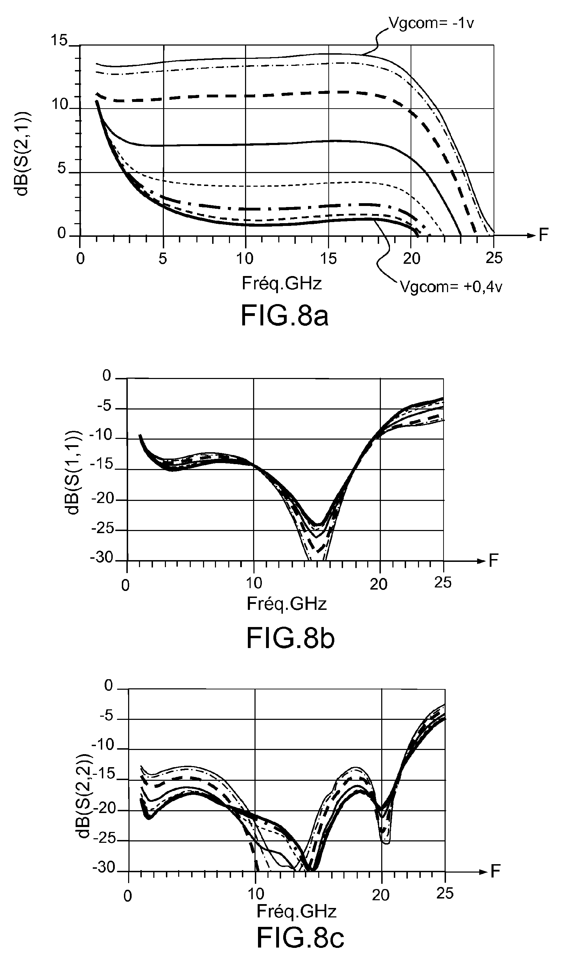

Les figures 8a, 8b et 8c montrent respectivement les paramètres S2,1 ; S1,1 et S2,2 d'un amplificateur distribué à contrôle de gain, selon l'invention, à quatre cellules amplificatrices Cl1, Cl2, Cl3, Cl4, en fonction de la fréquence F, lorsque la tension de commande Vgcom varie de -1 V (gain maximum) à +0,4V (gain minimum). On peut constater une variation homogène du gain sur une grande plage de fréquence et de très bons coefficients de réflexion (S11 et S2,2), aux accès de l'amplificateur distribué qui sont peu dépendants du niveau de gain.

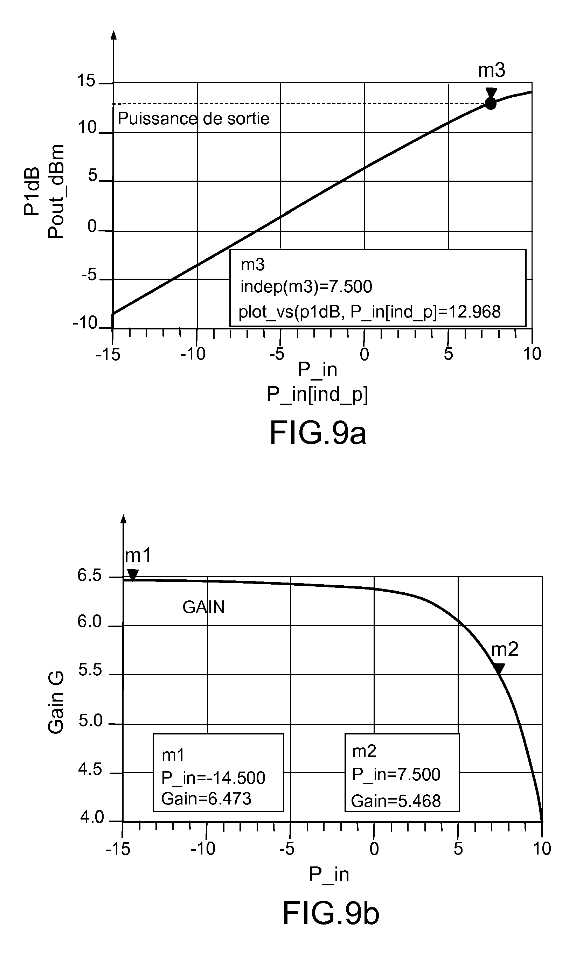

Les figures 9a et 9b représentent respectivement la puissance de sortie Pout et la variation du gain G (S2,1) de l'amplificateur distribué à quatre cellules amplificatrices en fonction de la puissance d'entrée Pin pour un réglage de gain faible, des cellules.

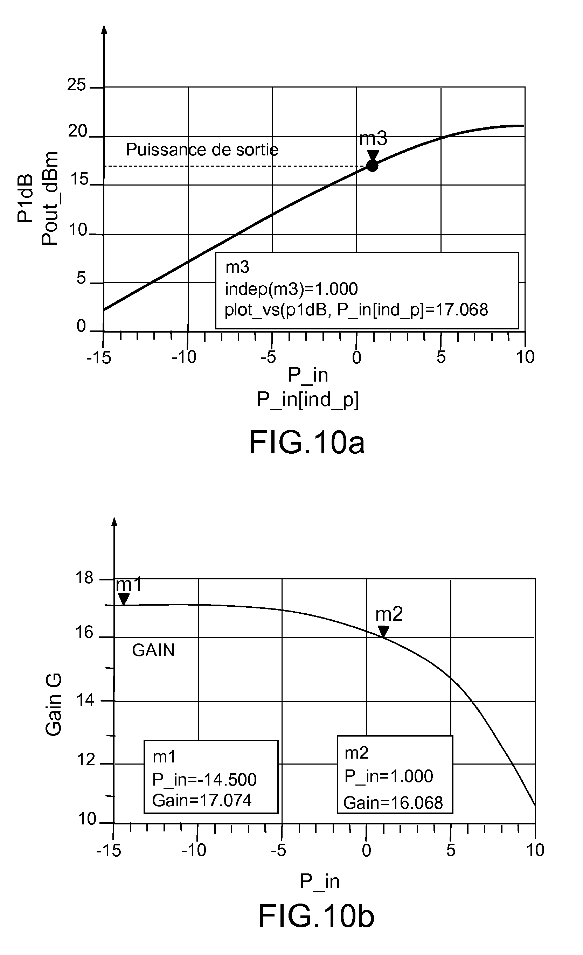

Les figures 10a et 10b représentent respectivement la puissance de sortie Pout et la variation du gain G de l'amplificateur distribué à quatre cellules amplificatrices en fonction de la puissance d'entrée Pin pour un réglage de gain fort, des cellules.
On s'intéresse ici à une caractéristique importante du circuit : la puissance de sortie Pout pour une compression de gain de 1 dB (notée P1dB sur l'axe des ordonnées), c'est à dire pour une puissance d'entrée générant une saturation du signal telle que le gain global est 1 dB plus faible que sa valeur en petit signal.
On constate que lorsque le gain chute de 11 dB environ, cette chute correspondant à la différence de gain entre le gain faible représenté à la Figure 9b et le gain fort, représenté à la Figure 10b, la puissance, à 1 dB de compression P1dB, ne chute que d'environ 4dB, soit la différence de puissance à P1dB entre la puissance repérée m3 sur la figure 9a et celle repérée m3 sur la figure 10a :
- P1dB=13dBm pour un gain d'environ 6 dB dans le premier cas (figure 9a),
- P1dB=17dBm pour un gain d'environ 17 dB dans le second cas (figure 10a).
   L'utilisation d'un atténuateur variable à la suite d'un amplificateur fixe impliquerait une chute de 11 dB de la puissance à 1dB de compression (P1dB) pour une chute de gain de 11dB.

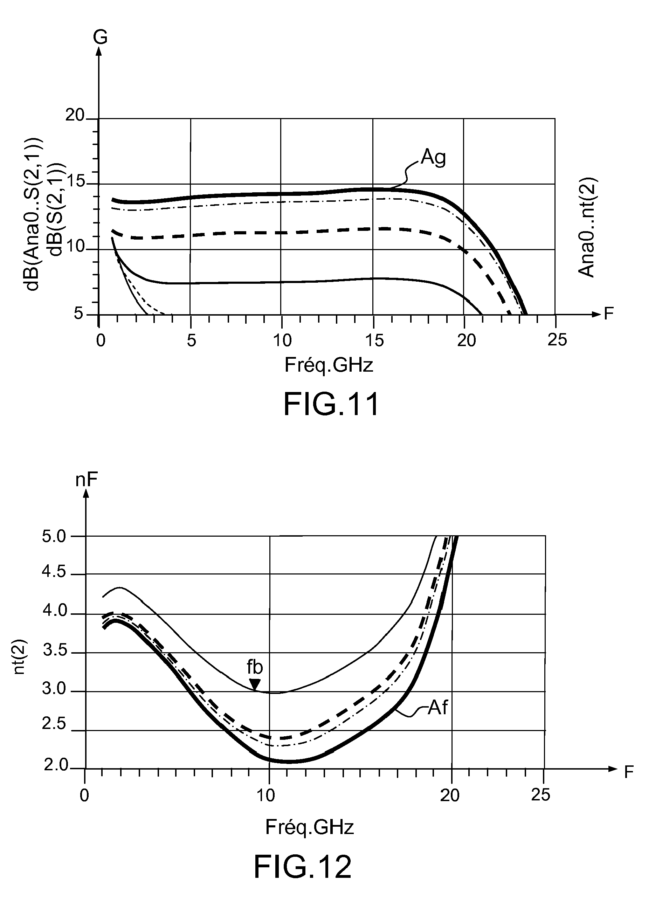

Les figures 11 et 12 montrent respectivement les variations de gain (S2,1) en fonction de la fréquence F et les variations relatives du facteur de bruit nF correspondant aux variations de gain de l'amplificateur distribué à quatre cellules amplificatrices, lorsque la tension de commande Vgcom varie de -1 V (gain maximum) à +0,4V (gain minimum).
Les courbes Ag et Af en trait épais des figures 11 et 12 montrent respectivement le gain et le facteur de bruit nf en fonction de la fréquence F du même amplificateur dépourvu de système de contrôle de gain. On constate que le bruit « plancher » fb de l'amplificateur à gain variable est supérieur d'environ 0,2 à 0,3 dB au bruit de l'amplificateur de référence. Ce chiffre aurait été bien supérieur (au moins 1 dB pour cette bande de fréquence) dans le cas d'un atténuateur variable précédant un amplificateur fixe.
La structure amplificatrice selon l'invention permet d'obtenir un bon compromis entre facteur de bruit et linéarité (puissance de sortie) pour la réalisation d'un amplificateur à gain commandable, comparée à une combinaison d'un atténuateur variable et d'un amplificateur fixe.

## Revendications

1. Cellule Amplificatrice hyperfréquences large bande à gain variable comportant, deux transistors à effet de champ en montage cascode, un premier transistor à effet de champ (T1) monté en source commune, sa source S étant connectée à un potentiel de référence (M), en série avec un deuxième transistor à effet de champ (T2) monté en grille commune, sa source S étant connectée au drain D du premier transistor à effet de champ (T1), sa grille G étant connectée au potentiel de référence (M) à travers une capacité de découplage de grille (Cd), une entrée E hyperfréquences par la grille du premier transistor à effet de champ (T1) et une sortie S hyperfréquences par le drain du deuxième transistor à effet de champ (T2),
entre le point commun de connexion du drain D du premier transistor à effet de champ (T1) avec la source S du deuxième transistor à effet de champ (T2) et le potentiel de référence (M), une capacité de découplage de circuit de réglage (Cr) en série avec un élément résistif (Rr) de valeur réglable pour faire varier le gain (G) de la cellule amplificatrice.
l'élément résistif étant un troisième transistor à effet de champ (T3) connecté entre sa source S et son drain D, sa grille G étant connectée à une source (Sr) de tension continue, de potentiel Vgcom variable, pour faire varier la résistance entre la source S et le drain D dudit troisième transistor à effet de champ (T3),
**caractérisée en ce qu'**elle comporte une résistance de grille (Rg) en série avec la capacité de découplage de grille (Cd) du deuxième transistor à effet de champ (T2) monté en grille commune pour améliorer stabilité du montage cascode à gain réglable.

2. Cellule Amplificatrice hyperfréquences selon la revendication 1, **caractérisée en ce qu'**elle comporte une entrée de commande (Cc) pour régler la valeur de l'élément résistif (Rr).

3. Amplificateur hyperfréquences large bande à gain variable comportant une entrée (Eamp) et une sortie (Samp) de signal hyperfréquences,
**caractérisé en ce qu'**il comporte un amplificateur distribué à n cellules amplificatrices (Cl1, Cl2,...Cli,...Cln) selon la revendication 2, l'amplificateur distribué comportant une ligne de transmission d'entrée (Lg) d'un signal d'entrée Ue appliqué à l'entrée (Eamp) de signal hyperfréquences, et une ligne de transmission de sortie (Ld) du signal d'entrée amplifié, les lignes étant activement couplées entre elles par les cellules amplificatrices Cl1, Cl2,...Cli,...Cln, n étant un entier supérieur à 1,
la ligne de transmission d'entrée (Lg) ayant une de ses deux extrémités reliée à l'entrée (Eamp) de signal hyperfréquences, la ligne de transmission de sortie (Ld) dudit signal d'entrée Ue amplifié ayant une extrémité de sortie de l'amplificateur distribué connectée à la sortie (Samp) de signal hyperfréquences, le gain (G) de l'amplificateur distribué étant fonction de la valeur identique, pour chacune des cellules amplificatrices, de l'élément résistif .

4. Amplificateur hyperfréquences selon la revendication 3, **caractérisé en ce que** les extrémités libres (10, 20) des deux lignes de transmission (Lg, Ld) sont chargés par des respectives impédances (Zg, Zd) de valeurs égales à l'impédance caractéristique de la respective ligne de transmission (Lg, Ld) à laquelle chacune est connectée.

5. Amplificateur hyperfréquences selon l'une des revendications 3 ou 4, **caractérisé en ce que,** l'élément résistif de valeur réglable des n cellules amplificatrices (Cl1, Cl2,...Cli,...Cln) étant le troisième transistor à effet de champ (T3) connecté entre sa source S et son drain D, sa grille G étant connectée à une source (Sr) de tension continue de potentiel Vgcom variable pour faire varier la résistance entre la source S et le drain D dudit troisième transistor à effet de champ (T3), il comporte une ligne de distribution commune dudit potentiel Vgcom variable aux n cellules.
